(19) Europäisches Patentamt / European Patent Office / Office européen des brevets

(11) **EP 4 395 002 A1**

(12) **EUROPEAN PATENT APPLICATION**

(43) Date of publication:
03.07.2024   Bulletin 2024/27

(21) Application number: 23209037.3

(22) Date of filing: 10.11.2023

(51) International Patent Classification (IPC):
$H01M\ 10/48^{(2006.01)}$   $H01M\ 10/04^{(2006.01)}$
$G01R\ 31/387^{(2019.01)}$   $G01R\ 31/392^{(2019.01)}$
$G01R\ 31/396^{(2019.01)}$   $H01M\ 10/42^{(2006.01)}$
$H01M\ 50/204^{(2021.01)}$   $H01M\ 10/0525^{(2010.01)}$

(52) Cooperative Patent Classification (CPC):
H01M 10/04; G01R 31/387; G01R 31/392;
G01R 31/396; H01M 10/4207; H01M 10/4285;
H01M 10/482; H01M 10/484; H01M 10/488;
H01M 50/204; H01M 10/0525

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 26.12.2022   JP 2022208371

(71) Applicant: Prime Planet Energy & Solutions, Inc.
Chuo-ku
Tokyo
103-0022 (JP)

(72) Inventor: SOEJIMA, Takanori
Tokyo, 103-0022 (JP)

(74) Representative: Kuhnen & Wacker
Patent- und Rechtsanwaltsbüro PartG mbB
Prinz-Ludwig-Straße 40A
85354 Freising (DE)

(54) **MANUFACTURING METHOD OF SECONDARY BATTERY AND UTILIZATION THEREOF**

(57)   A present disclosure provides a technique for manufacturing a secondary battery outstanding in a high rate resistant property with a high precision. The manufacturing method disclosed herein includes a constructing step S 10 for constructing an battery assembly in which an electrode body and an electrolytic solution are accommodated inside a battery case, an increase amount measuring step S20 for performing an inspection charge on the battery assembly for a predetermined period so as to measure an increase amount $L_\Delta$ of the excess electrolytic solution for the inspection charge, and a first judging step S30 for selecting the battery assembly, whose increase amount $L_\Delta$ of the excess electrolytic solution is equal to or less than a predetermined upper limit threshold $L_{MAX}$, as a good quality product. This wording "increase amount $L_\Delta$ of the excess electrolytic solution" represents an amount of the electrolytic solution having flown out to an outside of the electrode body due to an expansion of the electrode for the inspection charge, and thus it is possible to properly evaluate a high rate resistant property of the battery assembly. Therefore, by selecting the battery assembly, whose increase amount $L_\Delta$ of the excess electrolytic solution becomes equal to or less than an upper limit threshold $L_{MAX}$, as a good quality product, it is possible to manufacture the secondary battery outstanding in the high rate resistant property with a high precision.

FIG.1

EP 4 395 002 A1

## Description

BACKGROUND

1. Technical Field

A technique disclosed herein relates to a manufacturing method of a secondary battery and a technique in which the manufacturing method is used.

2. Description of the Related Art

The secondary battery, such as lithium ion secondary battery, has been widely used in various fields. This secondary battery has, for example, a configuration of accommodating an electrolytic solution and an electrode body in a battery case. Regarding the secondary battery having the configuration described above, the electrolytic solution is osmosed to an inside (electrode gap between a positive electrode and a negative electrode) of the electrode body. In addition, regarding this type of secondary battery, an excess electrolytic solution not osmosed to an inside of the electrode body might be caused at an outside of the electrode body (between the electrode body and the battery case). By doing this, it is possible to supply the electrolytic solution to the inside of the electrode body when a shortage of the electrolytic solution inside the electrode body is caused.

JP2021-170436 discloses a method for judging reusability of the secondary battery based on a liquid amount of the excess electrolytic solution. Particularly, an inspection method described in Patent Document 1 includes a step of radiating X-ray or ultrasonic to the secondary battery so as to measure a transmittance of it, a step of calculating an excess liquid amount of the electrolytic solution based on the transmittance, and a step of judging the ability of reusage of the secondary battery based on the excess liquid amount. By doing this, it is supposed that the ability of reusage of the secondary battery can be judged in a non-destructive manner.

SUMMARY

Anyway, regarding the secondary battery having the configuration described above, a degradation phenomenon (high rate deterioration) might be caused in which a battery resistance is drastically increased when a rapid charge is performed. This high rate deterioration is caused by the electrolytic solution inside the electrode body flowing out due to an expansion of the electrode (particularly, negative electrode) for the rapid charge. Thus, it is difficult to judge whether a resistant property to the high rate deterioration (high rate resistant property) is superior or not, even if measurement of the excess electrolytic solution is performed on the secondary battery being uncharged. The herein disclosed technique has been made in view of the above-described circumstances, and an object is to provide a technique of manufacturing a secondary battery outstanding in a high rate resistant property with a high precision.

In order to solve the above described circumstances, the herein disclosed technique can provide a manufacturing method of a secondary battery having a below described configuration (below, simply referred to as "manufacturing method", too).

The herein disclosed manufacturing method includes a constructing step for constructing a battery assembly in which an electrode body and an electrolytic solution are accommodated inside a battery case, includes an increase amount measuring step for performing an inspection charge on a battery assembly for a predetermined period to measure an increase amount $L_\Delta$ of an excess electrolytic solution for the inspection charge, and includes a first judging step for selecting a battery assembly, whose increase amount $L_\Delta$ of an excess electrolytic solution is equal to or less than a predetermined upper limit threshold $L_{MAX}$, as a good quality product.

As described above, in the manufacturing method disclosed herein, the increase amount $L_\Delta$ of the excess electrolytic solution for the inspection charge is measured. The wording "increase amount $L_\Delta$ of the excess electrolytic solution" represents an amount of the electrolytic solution having flown out to an outside of the electrode body due to an expansion of the electrode for the inspection charge. In other words, it is possible to consider the battery assembly, whose increase amount $L_\Delta$ of the excess electrolytic solution is smaller, as a battery in which the flow out of the electrolytic solution (high rate deterioration) for the charge is hardly caused. Thus, by selecting the battery assembly whose increase amount $L_\Delta$ of the excess electrolytic solution becomes equal to or less than the upper limit threshold $L_{MAX}$ as the good quality product, it is possible to manufacture the outstanding secondary battery in the high rate resistant property with the higher precision.

In addition, a suitable aspect of the herein disclosed manufacturing method further includes a second judging step for select a battery assembly, whose increase amount $L_\Delta$ of an excess electrolytic solution is equal to or more than a predetermined lower limit threshold $L_{MIN}$, as a good quality product. By doing this, it is possible to remove the battery assembly in which some abnormality might be caused on the charge and discharge response.

Additionally, in a suitable aspect of the herein disclosed manufacturing method, an increase amount $L_\Delta$ of an excess electrolytic solution is calculated by a below described formula (1), when a liquid amount of an excess electrolytic solution before start of an inspection charge is treated as an initial liquid amount $L_0$, a liquid amount of an excess electrolytic solution at a predetermined time for an inspection charge is treated as an inspection liquid amount $L_1$, and a total amount of an electrolytic solution existing inside a battery case is treated as a total liquid amount $L_T$. By doing this, it is possible to measure the increase amount $L_\Delta$ of the excess electrolytic solution in which the high rate resistant property of the battery assembly is accurately reflected.

$$L_\Delta = (L_1 - L_0)/L_T \qquad (1)$$

Additionally, in a suitable aspect of the herein disclosed manufacturing method, a liquid amount of an excess electrolytic solution is measured on a basis of an image analysis on an X-ray transmission image of a battery assembly. By doing this, it is possible to accurately measure the liquid amount of the excess electrolytic solution.

Additionally, in a suitable aspect of the herein disclosed manufacturing method, regarding an image analysis on an X-ray transmission image, a measurement line along a side surface of a battery case is set in an area between an electrode body and a battery case, and a change in luminance on the measurement line is analyzed, so as to measure a liquid amount of an excess electrolytic solution. By doing this, it is possible to more accurately measure the liquid amount of the excess electrolytic solution.

Additionally, in a suitable aspect of the herein disclosed manufacturing method, an X-ray transmission image is obtained by capturing a battery assembly in a state where the battery assembly is tilted by a predetermined tilt angle θ. By doing this, it is possible to more accurately measure the liquid amount of the excess electrolytic solution.

Additionally, in a suitable aspect of the herein disclosed manufacturing method, a battery case is formed with aluminum or resin. By doing this, it is possible to easily obtain the X-ray transmission image being clear.

Additionally, in a suitable aspect of the herein disclosed manufacturing method, an upper limit threshold $L_{MAX}$ is set to be within a range from 0.05% to 10%. By doing this, it is possible to manufacture the outstanding secondary battery particularly in the high rate resistant property with the higher precision.

Additionally, in a suitable aspect of the herein disclosed manufacturing method, an inspection liquid amount Li is measured at a time when a SOC of a battery assembly has reached a predetermined inspection value set to be within a range from 60% to 90%. By doing this, it is possible to measure the increase amount $L_\Delta$ of the excess electrolytic solution in which the high rate resistant property of the battery assembly is more accurately reflected.

In addition, as another aspect of the herein disclosed technique, a battery pack is provided. The herein disclosed battery pack at least includes plural single-batteries, and a connecting member configured to electrically connect each of plural single-batteries. Then, in the battery pack disclosed herein, 90% or more of plural single-batteries are secondary batteries, each comprising an increase amount $L_\Delta$ of an excess electrolytic solution for an inspection charge for a predetermined period being equal to or less than a predetermined upper limit threshold $L_{MAX}$.

According to the herein disclosed technique, it is possible to manufacture the outstanding secondary battery in the high rate resistant property with a high precision. As the result, it is possible to implement the battery pack, in which the most portion (90% or more) of the single-batteries included in the battery pack are secondary batteries outstanding in the high rate resistant properties. The battery pack described above can exhibit a high performance as a whole.

Additionally, in a suitable aspect of the herein disclosed battery pack, all of the plural single-batteries are secondary batteries, each comprising an increase amount $L_\Delta$ of an excess electrolytic solution being equal to or less than an upper limit threshold $L_{MAX}$. The battery pack described above can contribute to performing control capable of exhibiting a very high performance as a whole.

Additionally, in a suitable aspect of the herein disclosed battery pack, 20 or more of single-batteries are provided. According to the herein disclosed technique, even for the battery pack including 20 or more of multiple single-batteries, it is possible to construct the most portion of the battery pack with the secondary batteries outstanding in the high rate resistant properties.

BRIEF DESCRIPTION OF THE DRAWINGS

FIG. 1 is a flowchart for explaining a manufacturing method in accordance with one embodiment.
FIG. 2 is a perspective view that schematically shows an appearance of a battery assembly.
FIG. 3 is a longitudinal cross section view that schematically shows an inside structure of the battery assembly shown in FIG. 2.
FIG. 4 is a flowchart for explaining an example of an increase amount measuring step.
FIG. 5 is a longitudinal cross section view for explaining an example of a procedure of measuring a liquid amount of an excess electrolytic solution.
FIG. 6 is an example of an X-ray transmission image of the battery assembly.
FIG. 7 is a line profile that shows a change in luminance on a measurement line $M_L$ in FIG. 6.
FIG. 8 is a graph that shows a relation between an increase amount $L_\Delta$(%) of the excess electrolytic solution and a resistance increasing rate(%).
FIG. 9 is a perspective view that schematically shows an appearance of a battery pack in accordance with one embodiment.
FIG. 10 is a flowchart for explaining a manufacturing method in accordance with another embodiment.

DETAILED DESCRIPTION

<First embodiment>

Below, one embodiment of a herein disclosed technique will be described in detail, by reference to the accompanying drawings. Incidentally, the matters other than matters particularly mentioned in this specification, and required for practicing the herein disclosed technique can be grasped as design matters of those skilled in the art based on the related art in the present field. The herein disclosed technique can be executed based on the contents disclosed in the present specification, and the technical common sense in the present field. Additionally, in the following drawings, it will be explained while the members/parts providing the same effect are provided with the same numerals and signs. Furthermore, the dimensional relation (such as length, width, and thickness) in each drawing does not reflect the actual dimensional relation.

1. Manufacturing method of secondary battery

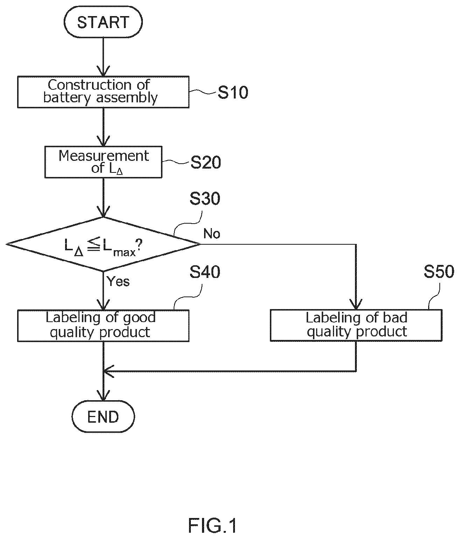

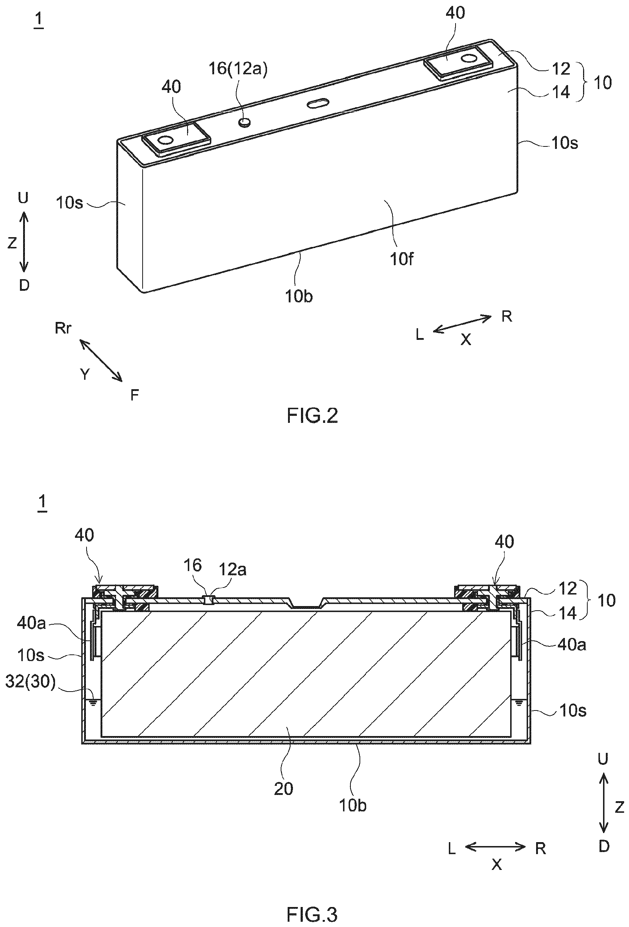

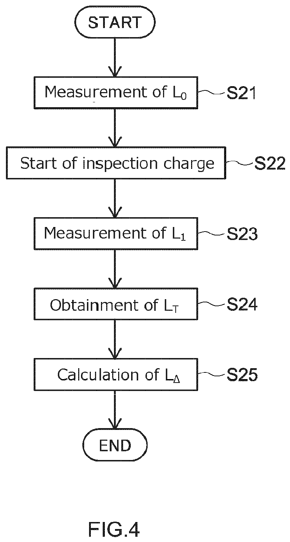

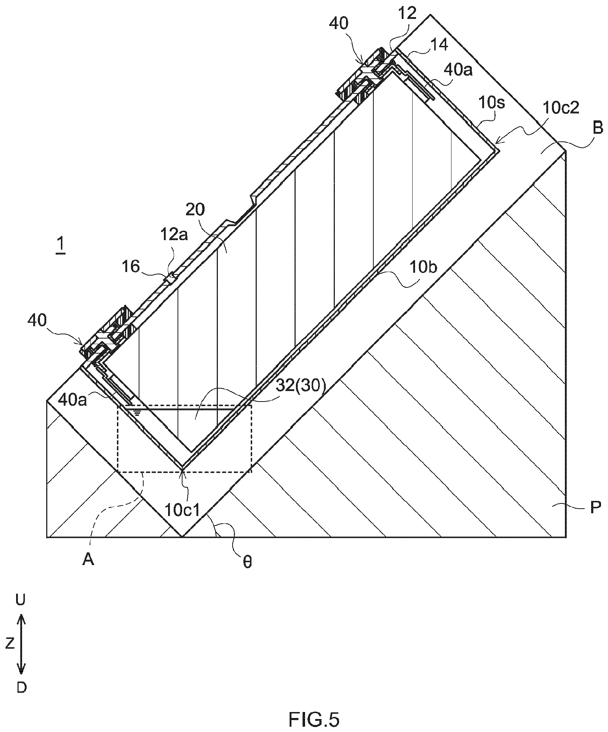

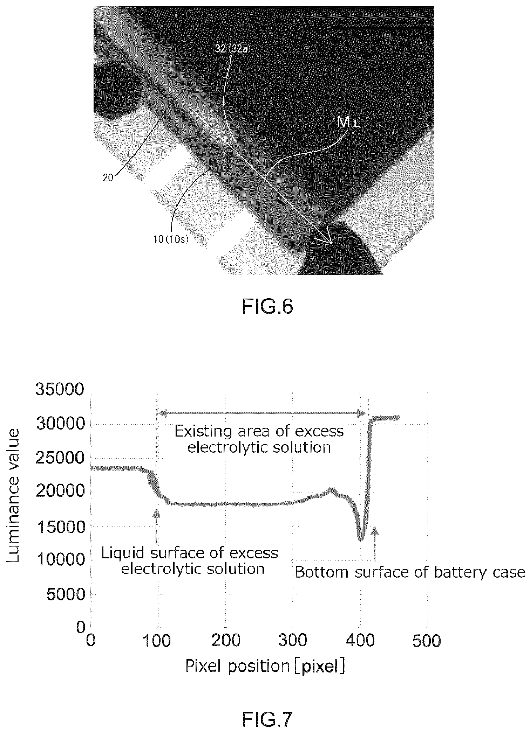

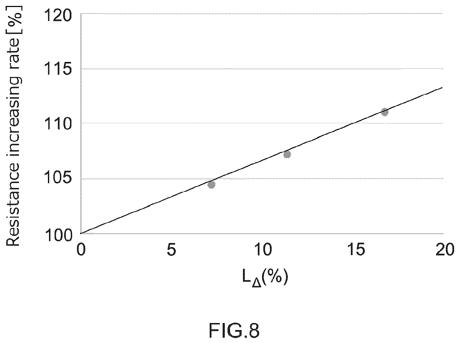

At first, one embodiment of a manufacturing method of a secondary battery disclosed herein will be described. FIG. 1 is a flowchart for explaining the manufacturing method in accordance with the present embodiment. FIG. 2 is a perspective view that schematically shows an appearance of a battery assembly. FIG. 3 is a longitudinal cross section view that schematically shows an inside structure of the battery assembly shown in FIG. 2. FIG. 4 is a flowchart for explaining an example of an increase amount measuring step. FIG. 5 is a longitudinal cross section view for explaining an example of a procedure of measuring a liquid amount of an excess electrolytic solution. FIG. 6 is an example of an X-ray transmission image of the battery assembly. FIG. 7 is a line profile that shows a change in luminance on a measurement line $M_L$ in FIG. 6. FIG. 8 is a graph that shows a relation between an increase amount $L_\Delta(\%)$ of the excess electrolytic solution and a resistance increasing rate (%). Incidentally, in drawings explained by the present specification, a reference sign X represents a width direction, a reference sign Y represents a depth direction, and a reference sign Z represents a height direction. Furthermore, reference signs L, R, F, Rr, U, and D respectively represent leftward, rightward, frontward, rearward, upward, and downward. However, these directions are defined for convenience sake of explanation, and they are not intended to restrict a use aspect of the secondary battery after it is manufactured.

As shown in FIG. 1, the manufacturing method in accordance with the present embodiment includes at least a constructing step S10, an increase amount measuring step S20 of an excess electrolytic solution, and a first judging step S30. In addition, the manufacturing method in accordance with the present embodiment further includes a good quality product labeling step S40, and a bad quality product labeling step S50, too. Below, each step will be described.

(1) Construction step S10

At the present step, a battery assembly 1 is constructed in which an electrode body 20 and an electrolytic solution 30 are accommodated inside a battery case 10 (see FIG. 2 and FIG. 3). Incidentally, the term "battery assembly" in the present specification represents a structure body in which a configuration element of a secondary battery is assembled in a chargeable and dischargeable manner, and for which a high rate resistant property is not evaluated. Then, the term "secondary battery" in the present specification represents a battery assembly that has a certain high rate resistant property and that is judged to be in a shipping-allowable condition. In other words, the battery assembly 1 shown in FIG. 2 and FIG. 3 has a configuration similar to the secondary battery after shipping, except for the later described steps S20 to S40 having not been performed yet. Below, an example of a structure of the battery assembly 1 will be explained.

(1-a) Battery case

The battery case 10 is a container formed in a box shape having an internal space. In the internal space of this battery case 10, the electrode body 20 and the electrolytic solution 30 are accommodated. Incidentally, as shown in FIG. 2 and FIG. 3, the battery case 10 in the present embodiment is a container formed in a flat rectangular parallelepiped shape. In particular, the battery case 10 includes a case main body 14 being a box-shaped member having an upper surface opening, and includes a sealing plate 12 being a plate-shaped member configured to cover the upper surface opening of this case main body 14. Incidentally, in a case where an X-ray transmission image is obtained at the later-described increase amount measuring step S20, it is preferable that the battery case 10 is formed with aluminum (which semantically includes aluminum alloy), resin, or the like. The battery case 10 formed with these materials has an X-ray transmission rate being higher, and thus it is possible at the increase amount measuring step S20 to obtain a clear X-ray transmission image.

In addition, the sealing plate 12 is provided with a liquid injection hole 12a configured to inject the electrolytic solution 30 to an inside of the battery case 10. Incidentally, this liquid injection hole 12a is sealed by a sealing member 16 after the electrolytic solution 30 is injected. Furthermore, to the sealing plate 12, a pair of electrode terminals 40 are attached. Each of the electrode terminals 40 is a structure body in which plural conductive members are combined, and which is configured to extend along a height direction Z. Then, an electrical collector member 40a configuring a lower end part of the electrode terminal 40 is connected to the electrode body 20 at the inside of the battery case 10.

(1-b) Electrode body

The electrode body 20 is a member in which a positive electrode and a negative electrode are opposed via a separator. As an example of the structure of the electrode body 20 described above, it is possible to use a wound electrode body, a laminate type electrode body, or the like. The wound electrode body is formed by winding the positive electrode formed in a long sheet shape, the negative electrode formed in a long sheet shape, and the separator formed in a long sheet shape. On the other hand, the laminate type electrode body is formed by alternately laminating the positive electrode being short and the negative electrode being short to dispose the separator at a gap between electrodes. Incidentally, regarding a configuration member (positive electrode, negative electrode, separator, or the like) of the electrode body 20 can be used materials capable of being utilized in a general secondary battery without particular restriction. That is, the configuration member of the electrode body does not restrict the herein disclosed technique. Thus a detailed explanation of the configuration member is omitted in this specification.

(1-c) Electrolytic solution

The electrolytic solution 30 is an electrolyte in liquid form that can make a charge carrier move between the positive electrode and the negative electrode. The most portion of the electrolytic solution 30 is osmosed to the inside of the electrode body 20 (electrode gap between the positive electrode and the negative electrode). Additionally, in the present embodiment, at an outside of the electrode body 20 (between the electrode body 20 and the battery case 10), there is an excess electrolytic solution 32 not osmosed to the inside of the electrode body 20. Thus, when a shortage of the electrolytic solution 30 inside the electrode body 20 is caused, it is possible to supply the electrolytic solution 30 to the inside of this electrode body 20. Incidentally, regarding the electrolytic solution 30, it is also possible to use one capable of being utilized in the general secondary battery without particular restriction.

(2) Increase amount measuring step S20

At the increase amount measuring step S20 of the excess electrolytic solution, an inspection charge is performed on the battery assembly 1 for a predetermined period, so as to measure an increase amount $L_\Delta$ of the excess electrolytic solution for this inspection charge. This wording "increase amount $L_\Delta$ of the excess electrolytic solution" represents an amount of the electrolytic solution 30 having flown out to the outside of the electrode body 20 due to an expansion of the electrode for the inspection charge. In other words, it is possible to consider that a high rate deterioration due to the electrolytic solution 30 having flown out tends to be more easily caused on the battery assembly 1, whose increase amount $L_\Delta$ of the excess electrolytic solution is larger. On the other hand, it is possible to consider that the battery assembly 1, whose increase amount $L_\Delta$ of the excess electrolytic solution is smaller, is more superior in the high rate resistant property.

Below, an example of a measurement procedure for "increase amount $L_\Delta$ of the excess electrolytic solution" at the increase amount measuring step S20 will be explained. As shown in FIG. 4, the increase amount measuring step S20 in the present embodiment includes a measurement S21 of an initial liquid amount $L_0$, a start S22 of the inspection charge, a measurement S23 of an inspection liquid amount $L_1$, an obtainment S24 of a total liquid amount $L_T$, and a calculation S25 of the increase amount $L_\Delta$.

(2-a) Measurement S21 of initial liquid amount $L_0$

At this increase amount measuring step S20, firstly, the measurement S21 of the initial liquid amount $L_0$ is performed. The term "initial liquid amount $L_0$" measured here means a liquid amount (ml) of the excess electrolytic solution before the start of the inspection charge. Incidentally, it is preferable that the battery assembly 1 used at the measurement S21 of the initial liquid amount $L_0$ is the battery assembly 1 after an initial charge and discharge operation and an aging processing are performed. By doing this, it is possible as "initial liquid amount $L_0$" to use the liquid amount of the excess electrolytic solution of the battery assembly 1 in which a distribution nonuniformity of the electrolytic solution 30 inside the electrode body 20 is small, and thus it is possible to accurately calculate the later described increase amount $L_\Delta$ of the excess electrolytic solution. In particular, it is preferable that the battery assembly whose SOC after the aging processing is 10% to 20% (for example, about 17%) is selected as a target for the measurement S21 of the initial liquid amount $L_0$.

Incidentally, it is preferable that "liquid amount (ml) of the excess electrolytic solution" is measured on the basis of an image analysis on an X-ray transmission image of the battery assembly 1. By doing this, it is possible to accurately measure the liquid amount of the excess electrolytic solution 32. Below, it will be particularly explained about measurement of the liquid amount of the excess electrolytic solution with the X-ray transmission image.

At first, it is preferable that the X-ray transmission image of the battery assembly 1 is obtained by capturing the battery assembly 1 in a state where the battery assembly is tilted by a predetermined tilt angle θ. For example, in an example shown by FIG. 5, the battery assembly 1 held by a restricting member B is mounted on a pedestal P including an installation surface tilted by a predetermined tilt angle θ (for example, 45°). By doing this, the excess electrolytic solution 32 is gathered to a vicinity of a corner part 10c1, which is arranged downward D in a height direction Z, among corner parts 10c1, 10c2 of the battery case 10 at a bottom surface 10b side. By capturing the X-ray transmission image of an area A including the above described corner part 10c1 under this state, it is possible to implement an accurate measurement even when the liquid amount of the excess electrolytic solution 32 is smaller. Incidentally, it is preferable that a capturing condition of the X-ray transmission image is suitably adjusted to be a condition capable of accurately recognizing a liquid surface 32a of the excess electrolytic solution 32. As an example, it is preferable that a pipe voltage of an X-ray radiating apparatus is set to be within a range from 125 kV to 175 kV (for example, 150 kV). In addition, it is preferable that a pipe current is set to be within a range from 175 $\mu$A to 225 $\mu$A (for example, 200 $\mu$A).

In addition, as described above, regarding the present embodiment, the X-ray transmission image is captured under a state where a flat surface 10f (see FIG. 2) of the battery case 10 is sandwiched by a pair of restricting members B and then a restriction pressure is applied. By doing this, it is possible to evaluate the high rate resistant property under a state where an actual use situation of the secondary battery is properly reflected. Incidentally, it is preferable that the restriction pressure at that time is set to add a load of 15 kN to 25 kN (for example, about 20 kN) with respect to the battery assembly 1 whose SOC is 17%. In addition, it is preferable that the restricting member B is a member made from a transparent resin. By doing this, it is possible to obtain the X-ray transmission image on which the image analysis is easily performed.

Next, an example of a procedure of analyzing the X-ray transmission image will be explained while referring to FIG. 6. In this image analysis, at first, a measurement line $M_L$ extending along a side surface 10s of the battery case 10 is set on an area between the electrode body 20 and battery case 10 of the captured X-ray transmission image. Then, a predetermined image analyzing software (Image-J, or the like) is used to analyze a change in luminance along the measurement line $M_L$. For example, regarding an analysis result shown by FIG. 7, a luminance value is drastically reduced near 100 pixel. This is because the X-ray transmission rate on an area where the excess electrolytic solution 32 exists is low. In other words, regarding FIG. 7, it is possible to consider that the liquid surface 32a of the excess electrolytic solution 32 exists at a position near 100 pixel. Next, regarding FIG. 7, the luminance value is further reduced at a position near 400 pixel. This is because it reaches the bottom surface 10b of the battery case 10 whose X-ray transmission property is little. Thus, based on the analysis result shown by FIG. 7, it is possible to analyze that the excess electrolytic solution 32 exists on an area of 100 to 400 pixel. Then, in the present embodiment, a preliminary test is performed in advance for defining a relational expression between "existing area (pixel) of the excess electrolytic solution 32 on the X-ray transmission image" and "actual liquid amount (ml) of the excess electrolytic solution". By doing this, it is possible to measure the liquid amount (ml) of the excess electrolytic solution based on the existing area of the excess electrolytic solution 32 on the X-ray transmission image.

(2-b) Start S22 of inspection charge

Next, at the increase amount measuring step S20, the inspection charge is started to charge the battery assembly 1 under a predetermined condition (S22). Incidentally, the condition of the inspection charge is set to make the electrolytic solution 30 flow out due to the expansion of the electrode body 20. For example, it is preferable regarding the inspection charge that a so-called rapid charge (high rate charge) is performed. By doing this, a certain amount or more of the electrolytic solution 30 flows out for the inspection charge, and thus calculating the increase amount $L_A$ of the excess electrolytic solution becomes easy. Incidentally, a detailed condition of the inspection charge is suitably set on the basis of a size, a material, or the like, of the battery assembly 1, which is not an element restricting the herein disclosed technique, and thus the detailed explain is omitted.

(2-c) Measurement S23 of inspection liquid amount Li

Next, at the increase amount measuring step S20, the measurement S23 of the inspection liquid amount Li is performed. The term "inspection liquid amount Li" measured here means the liquid amount (mL) of the excess electrolytic solution at a predetermined time for the inspection charge. For example, the inspection liquid amount Li is measured when the SOC of the battery assembly 1 reaches an inspection value being set within a range from 60% to 90% (for example, about 78%). By doing this, it is possible as "inspection liquid amount Li" to use the liquid amount of the excess electrolytic solution in a state where the inspection charge has been sufficiently progressed, and thus the high rate resistant property of the battery assembly 1 can be evaluated further accurately. In addition, the inspection liquid amount Li can be measured with a procedure the same as the initial liquid amount $L_0$, except for a measurement target set to be the battery assembly 1 for the inspection charge. In other words, the inspection liquid amount Li can be measured on the basis of the image analysis on the X-ray transmission image of the battery assembly 1. Regarding this measurement of the inspection liquid amount Li based on the X-ray transmission image, the explanation here is omitted because it becomes an overlapped explanation.

(2-d) Obtainment S24 of total liquid amount $L_T$

At the increase amount measuring step S20, next, a total amount (total liquid amount $L_T$) of the electrolytic solution 30 existing in the battery case 10 is obtained (S24). Here, the term "total liquid amount $L_T$" means a total amount in which the excess electrolytic solution 32 existing at an outside of the electrode body 20 and the electrolytic solution 30 osmosed to the inside of the electrode body 20 are added. By reflecting the total liquid amount $L_T$ on a later described calculation of the increase amount $L_\Delta$ of the excess electrolytic solution, it is possible to evaluate the high rate resistant property of the battery assembly 1, without being influenced by an injected liquid amount of the electrolytic solution 30. Incidentally, it is possible as the total liquid amount $L_T$ of the electrolytic solution 30 to use a standard value at a battery design time, or to use an actual measurement value measured at the battery assembly 1 construction time (at the liquid injection of the electrolytic solution 30).

(2-e) Calculation S25 of increase amount $L_\Delta$

Then, at the present step, the increase amount $L_\Delta$ of the excess electrolytic solution is calculated on the basis of each of parameters obtained at S21 to S24 (S25). In particular, the increase amount $L_\Delta$ of the excess electrolytic solution can be calculated by Formula (1) described below, on the basis of the initial liquid amount $L_0$, the inspection liquid amount $L_1$, and the total liquid amount $L_T$. This increase amount $L_\Delta$ of the excess electrolytic solution is a value in which amounts ($L_1-L_0$) of the electrolytic solution, having flown out to the outside of the electrode body due to the expansion of the electrode for the inspection charge, is standardized by the total liquid amount $L_T$ of the electrolytic solution 30.

$$L_\Delta = (L_1-L_0)/L_T \qquad (1)$$

(3) First judging step S30

Next, regarding the manufacturing method in accordance with the present embodiment, the first judging step S30 is performed to select the battery assembly 1, whose increase amount $L_\Delta$ of the excess electrolytic solution is equal to or less than a predetermined upper limit threshold $L_{MAX}$, as the good quality product. In particular, at the first judging step S30, the increase amount $L_\Delta$ of the excess electrolytic solution and the upper limit threshold $L_{MAX}$ are compared. At that time, the upper limit threshold $L_{MAX}$ is suitably set in response to a standard of the secondary battery being a manufacture target. For example, the upper limit threshold $L_{MAX}$ might be set to be within a range from 0.05% to 10%.

Then, when the increase amount $L_\Delta$ of the excess electrolytic solution exceeds the upper limit threshold $L_{MAX}$ (S30: in a case of NO), it can be considered that a large amount of electrolytic solutions 30 are flowing out from the electrode body 20 for the inspection charge. In that case, the battery assembly 1 being an inspection target is judged to be a battery whose high rate resistant property is low, and then subjected to the bad quality product labeling step S50. At the bad quality product labeling step S50, labeling is performed to show that the battery assembly 1 being the inspection target is a bad quality product. Then, the battery assembly 1 after the bad quality product labeling is subjected to a reinspection operation, a correction processing, a disposal operation, or the like.

On the other hand, when the increase amount $L_\Delta$ of the excess electrolytic solution is equal to or less than the upper limit threshold $L_{MAX}$ (S30: in a case of YES), it can be understood that a flow-out amount of the electrolytic solution 30 for the inspection charge is small. In that case, the battery assembly 1 being the inspection target is judged to be a battery outstanding in the high rate resistant property, and then subjected to the good quality product labeling step S40. At the good quality product labeling step S40, labeling is performed to show that the battery assembly 1 being the inspection target is a good quality product. Then, the battery assembly 1 after the good quality product labeling is judged to be a secondary battery capable of being shipped, and then shipped after a required postprocessing (for example, construction of the battery pack, or the like) is performed.

(4) Summary

As described above, regarding the manufacturing method of the secondary battery in accordance with the present embodiment, the increase amount $L_\Delta$ of the excess electrolytic solution for the inspection charge is measured, and then whether the battery assembly 1 is good or bad is judged on the basis of this increase amount $L_\Delta$ of the excess electrolytic solution. This increase amount $L_\Delta$ of the excess electrolytic solution represents an amount of the electrolytic solution 30 having flown out due to the expansion of the electrode for the inspection charge. In other words, it can be said that the battery assembly 1, whose increase amount $L_\Delta$ of the excess electrolytic solution is small, is a battery in which the flow-out of the electrolytic solution 30 in the charge time is hardly caused and which is superior in the high rate resistant property. These things are supported by experiments that have been performed by the present inventor, too. In particular, as shown in FIG. 8, it is confirmed that the smaller increase amount $L_\Delta$(%) of the excess electrolytic solution for the inspection charge induces the lower resistance increasing rate for the high rate charge. As described above, regarding the manufacturing method in accordance with the present embodiment, whether the battery assembly 1 is good or bad is judged on the basis of the increase amount $L_\Delta$ of the excess electrolytic solution, and thus it is possible to manufacture the secondary battery outstanding in the high rate resistant property with the high precision.

2. Battery pack

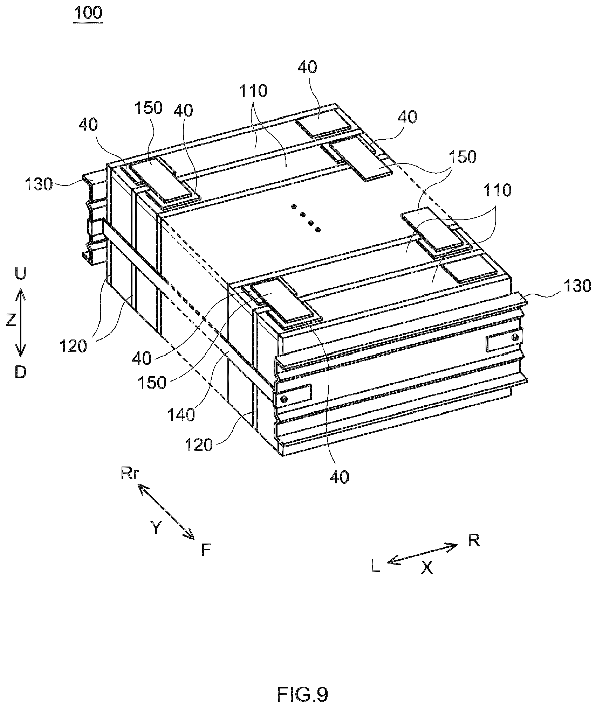

Next, the manufacturing method in accordance with the present embodiment can contribute to performance improvement of the battery pack 100 having a configuration as shown in FIG. 9. Below, it will be particularly explained.

As shown in FIG. 9, the battery pack 100 in accordance with the present embodiment includes plural single-batteries 110. Each of the single-batteries 110 is arranged to make a flat surface 10f (see FIG. 2) of the battery case 10 mutually opposed. In addition, a spacer 120 is arranged between the adjacent 2 single-batteries 110. Then, these plural single-batteries 110 are sandwiched by a pair of restriction plates 130. Said pair of restriction plates 130 are connected by a cross-linking member 140 that is configured to extend along an arrangement direction (depth direction Y in FIG. 9). By doing this, each of the single-batteries 110 is restricted by a certain restriction pressure. In addition, the battery pack 100 shown in FIG. 9 includes a connecting member 150 that is configured to electrically connect each of the plural single-batteries 110. This connecting member 150 is configured to connect electrode terminals 40 of the adjacent single-batteries 110. By doing this, it is possible to use the battery pack 100 including the plural single-batteries 110, as one battery unit.

Then, regarding the battery pack 100 in accordance with the present embodiment, the secondary battery whose increase amount $L_\Delta$ of the excess electrolytic solution is equal to or less than upper limit threshold $L_{MAX}$ is used in 90% or more of the plural single-batteries 110. In other words, the most portion of the single-batteries 110 in the present embodiment are the secondary batteries that have been judged as good quality products at the first judging step S30. By doing this, it is possible to construct the battery pack 100 whose most portion is occupied by the single-batteries outstanding in the high rate resistant property, and thus the high rate deterioration is hardly caused even when the rapid charge and discharge is performed. Therefore, the battery pack 100 in accordance with the present embodiment can exhibit a high performance as a whole of the battery unit.

Incidentally, when the manufacturing method described above is used, it is also possible to implement the battery pack 100 in which all of the plural single-batteries 110 (100%) become the secondary batteries outstanding in the high rate resistant property (whose increase amount $L_\Delta$ of the excess electrolytic solution becomes equal to or less than the upper limit threshold $L_{MAX}$). The battery pack 100 described above can contribute to performing a charge and discharge control exhibiting a particularly high performance. In particular, regarding a general battery pack, the charge and discharge control is performed with making the single-battery having the lowest high-rate resistant property be treated as a reference, in order to inhibit the high rate deterioration as for the battery unit. Thus, in a case where the single-battery having the lower high-rate resistant property is contaminated in the plural single-batteries, the control is performed in which the rapid charge and discharge is restricted, even if the other single-batteries have the higher high-rate resistant properties. On the other hand, when the manufacturing method in accordance with the present embodiment is used, the battery pack 100 is constructed with only the outstanding single-batteries 110 in the high rate resistant property, and thus it is possible to implement the charge and discharge control repeating the rapid charge and discharge, which has been difficult to be implemented conventionally.

In addition, the herein disclosed technique can be suitably applied to the battery pack 100 in which the number of the single-batteries 110 is 20 or more (further suitably 40 or more, furthermore suitably 60 or more, or in particular suitably 80 or more), particularly. According to the technique disclosed herein, it is possible to easily implement the battery pack whose most portion is occupied with the outstanding single-batteries in the high rate resistant property, even when the battery pack 100 is provided with so many single-batteries 110.

<Another embodiment>

Above, an embodiment of the manufacturing method disclosed herein is explained. Incidentally, the herein disclosed manufacturing method is not restricted to the above described embodiment, and various matters can be changed suitably. Below, an example of the matter capable of being changed from the above described embodiment will be described.

1. Addition of second judging step

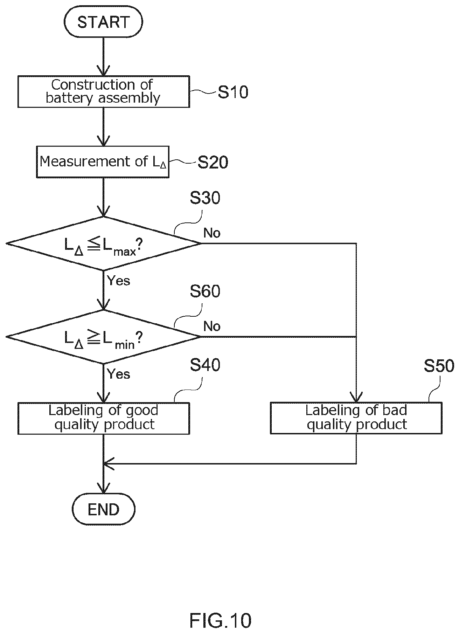

In the manufacturing method according to the above described embodiment, the first judging step S30 is performed in which the increase amount $L_\Delta$ of the excess electrolytic solution for the inspection charge and the upper limit threshold $L_{MAX}$ are subjected to a comparison judgment. However, the manufacturing method disclosed herein might include a judging step other than the first judging step S30. For example, in the manufacturing method shown by FIG. 10, a second judging step S60 is performed on the battery assembly 1 whose increase amount $L_\Delta$ of the excess electrolytic solution has become equal to or less than upper limit threshold $L_{MAX}$ (S30 has become YES). At this second judging step S60, the increase amount $L_\Delta$ of the excess electrolytic solution and a lower limit threshold $L_{MIN}$ are compared. Here, in a case where the increase amount $L_\Delta$ of the excess electrolytic solution is less than the lower limit threshold $L_{MIN}$ (S60: in a case of NO), it is judged that some failure might be caused. In particular, even when the battery outstanding in the high rate resistant property is used, the electrode for the inspection charge is expanded a little, and thus the increase amount $L_\Delta$ of the excess electrolytic solution being equal to or more than a certain value is observed. On the other hand, when little flow-out of the electrolytic solution for the inspection charge is observed, some defective issue (defective issue of inspection charge, defective issue of X-ray transmission image analysis, or the like) might be caused on the measurement of the increase amount $L_\Delta$ of the excess electrolytic solution. However, by providing the comparison judgment with the lower limit threshold $L_{MIN}$ representing the increase amount $L_\Delta$ of the excess electrolytic solution being equal to or more than the certain value, it is possible to secure properly performing the measurement of the increase amount $L_\Delta$ of the excess electrolytic solution. By doing this, it is possible to further enhance a reliability of the secondary battery manufactured with the herein disclosed manufacturing method. Incidentally, similarly to the above described upper limit threshold $L_{MAX}$, the lower limit threshold $L_{MIN}$ is also suitably set in response to the standard of the secondary battery being the manufacture target, and is not restricted to a specific value. As an example, the lower limit threshold $L_{MIN}$ can be set within a range from 0% to 0.03%.

2. Measurement timing for inspection liquid amount

In the above described embodiment, only one increase amount $L_\Delta$ of the excess electrolytic solution is calculated on the basis of the initial liquid amount $L_0$ and the inspection liquid amount $L_1$, and whether the battery assembly 1 is good or bad is judged on the basis of said one increase amount $L_\Delta$ of the excess electrolytic solution. However, a timing for or number of measuring the increase amount $L_\Delta$ of the excess electrolytic solution does not restrict the herein disclosed technique. For example, measuring the inspection liquid amount might be performed on each occasion that the SOC rises by a certain amount (for example, about 5%) for the inspection charge, so as to obtain the plural inspection liquid amounts $L_i$ to $L_N$. Then, by using these plural inspection liquid amounts $L_1$ to $L_N$, it is possible to perform plural calculations of the increase amounts $L_{\Delta 1}$ to $L_{\Delta N}$ of the excess electrolytic solutions. Then, by respectively comparing these increase amounts $L_{\Delta 1}$ to $L_{\Delta N}$ of the excess electrolytic solutions and the plural upper limit thresholds $L_{MAX1}$ to $L_{MAXN}$, it is possible to evaluate the high rate resistant property in a time dependent manner in response to SOC change.

3. Measuring means for increase amount $L_\Delta$ of the excess electrolytic solution

In the above described embodiment, the liquid amount (initial liquid amount $L_0$, and inspection liquid amount $L_i$) of the excess electrolytic solution is measured on the basis of the image analysis on the X-ray transmission image, and the increase amount $L_\Delta$ of the excess electrolytic solution is calculated on the basis of the measurement result. However, the means for measuring the liquid amount of the excess electrolytic solution is not restricted to the image analysis on the X-ray transmission image. For the herein disclosed technique, a means conventionally known for grasping the liquid amount of the excess electrolytic solution in the battery case can be used without particular restriction. For example, the liquid amount of the excess electrolytic solution can be measured by using a voltage value at a full-charged time, a change amount in the voltage for the charge and discharge, or the like. A means for using the voltage value at the full-charged time is disclosed in Japanese Patent Application Publication No. 2022-44621. In addition, a means for using the change amount in the voltage for the charge and discharge is disclosed in Japanese Patent Application Publication No. 2021-182474. Furthermore, as described in Patent Document 1, the liquid amount of the excess electrolytic solution can be measured on the basis of the image analysis on an ultrasonic image of the battery assembly, too. For the image analysis on the ultrasonic image at that time, similarly to the image analysis on the X-ray transmission image described above, it is possible to use a method based on a luminance analysis on the image. The manufacturing method disclosed herein includes a technique of using the above described measuring technique to measure the increase amount $L_\Delta$ of the excess electrolytic solution for the inspection charge so as to perform the first judging step based on this increase amount $L_\Delta$ of the excess electrolytic solution. However, the liquid amount of the excess electrolytic solution based on the voltage value is a so-called estimated value, and thus might be different from the actual liquid amount of the excess electrolytic solution. Accordingly, in consideration of the precision property of the measurement result, it is preferable to use a means capable of directly measuring the liquid amount of the excess electrolytic solution (image analysis on X-ray transmission image or ultrasonic image, or the like).

Above, the embodiments of the herein disclosed technique have been explained. However, the above described explanation is merely an illustration, and is not to restrict the scope of claims. The technique recited in the scope of claims includes contents in which the specific examples illustrated in the above explanation are variously deformed or changed.

In other words, the herein disclosed technique contains contents of [Item 1] to [Item 12] described below.

[Item 1]

A manufacturing method of a secondary battery, comprising:

a constructing step for constructing a battery assembly in which an electrode body and an electrolytic solution are accommodated inside a battery case; an increase amount measuring step for performing an inspection charge on the battery assembly for a predetermined period to measure an increase amount $L_\Delta$ of an excess electrolytic solution for the inspection charge; and

a first judging step for selecting the battery assembly, whose increase amount $L_\Delta$ of the excess electrolytic solution is equal to or less than a predetermined upper limit threshold $L_{MAX}$, as a good quality product.

[Item 2]

The manufacturing method recited in item 1, further comprising a second judging step for select the battery assembly, whose increase amount $L_\Delta$ of the excess electrolytic solution is equal to or more than a predetermined lower limit threshold $L_{MIN}$, as a good quality product.

[Item 3]

The manufacturing method recited in item 1 or 2, wherein

the increase amount $L_\Delta$ of the excess electrolytic solution is calculated by a below described formula (1), when a liquid amount of the excess electrolytic solution before start of the inspection charge is treated as an initial liquid amount $L_0$, the liquid amount of the excess electrolytic solution at a predetermined time for the inspection charge is treated as an inspection liquid amount $L_1$, and a total amount of the electrolytic solution existing inside the battery case is treated as a total liquid amount $L_T$.

$$L_\Delta = (L_1-L_0)/L_T \qquad (1)$$

[Item 4]

The manufacturing method recited in item 3, wherein

the liquid amount of the excess electrolytic solution is measured on a basis of an image analysis on an X-ray transmission image of the battery assembly.

[Item 5]

The manufacturing method recited in item 4, wherein

regarding the image analysis on the X-ray transmission image, a measurement line along a side surface of the battery case is set in an area between the electrode body and the battery case, and a change in luminance on the measurement line is analyzed, so as to measure the liquid amount of the excess electrolytic solution.

[Item 6]

The manufacturing method recited in item 4 or 5, wherein

the X-ray transmission image is obtained by capturing the battery assembly in a state where the battery assembly is tilted by a predetermined tilt angle θ.

[Item 7]

The manufacturing method recited in any one of items 4 to 6, wherein

the battery case is formed with aluminum or resin.

[Item 8]

The manufacturing method recited in any one of items 3 to 7, wherein

the upper limit threshold $L_{MAX}$ is set to be within a range from 0.05% to 10%.

[Item 9]

The manufacturing method recited in any one of items 3 to 8, wherein

the inspection liquid amount Li is measured at a time when a SOC of the battery assembly has reached a predetermined inspection value set to be within a range from 60% to 90%.

[Item 10]

A battery pack, at least comprising:

plural single-batteries; and
a connecting member configured to electrically connect each of the plural single-batteries, wherein 90% or more of the plural single-batteries are secondary batteries, each comprising an increase amount $L_\Delta$ of an excess electrolytic solution for an inspection charge for a predetermined period, the increase amount $L_\Delta$ being equal to or less than a predetermined upper limit threshold $L_{MAX}$.

[Item 11]

The battery pack recited in item 10, wherein all of the plural single-batteries are the secondary batteries, each comprising the increase amount $L_\Delta$ of the excess electrolytic solution being equal to or less than the upper limit threshold $L_{MAX}$.

[Item 12]

The battery pack recited in item 10 or 11, wherein

20 or more of the single-batteries are provided.

**Claims**

**1.** A manufacturing method of a secondary battery, comprising:

a constructing step for constructing a battery assembly (1) in which an electrode body (20) and an electrolytic solution (30) are accommodated inside a battery case (10);
an increase amount measuring step for performing an inspection charge on the battery assembly (1) for a predetermined period to measure an increase amount LΔ of an excess electrolytic solution (32) for the inspection charge; and
a first judging step for selecting the battery assembly (1), whose increase amount LΔ of the excess electrolytic solution (32) is equal to or less than a predetermined upper limit threshold LMAX, as a good quality product.

2. The manufacturing method according to claim 1, further comprising a second judging step for select the battery assembly (1), whose increase amount LΔ of the excess electrolytic solution (32) is equal to or more than a predetermined lower limit threshold LMIN, as a good quality product.

3. The manufacturing method according to claim 1 or 2, wherein
the increase amount LΔ of the excess electrolytic solution (32) is calculated by a below described formula (1), when a liquid amount of the excess electrolytic solution (32) before start of the inspection charge is treated as an initial liquid amount L0, the liquid amount of the excess electrolytic solution (32) at a predetermined time for the inspection charge is treated as an inspection liquid amount L1, and a total amount of the electrolytic solution (30) existing inside the battery case (10) is treated as a total liquid amount LT.

$$L\Delta = (L1 - L0)/LT \qquad (1)$$

4. The manufacturing method according to claim 3, wherein
the liquid amount of the excess electrolytic solution (32) is measured on a basis of an image analysis on an X-ray transmission image of the battery assembly (1).

5. The manufacturing method according to claim 4, wherein
regarding the image analysis on the X-ray transmission image, a measurement line (ML) along a side surface of the battery case (10) is set in an area between the electrode body (20) and the battery case (10), and a change in luminance on the measurement line is analyzed, so as to measure the liquid amount of the excess electrolytic solution (32).

6. The manufacturing method according to claim 4 or 5, wherein
the X-ray transmission image is obtained by capturing the battery assembly (1) in a state where the battery assembly (1) is tilted by a predetermined tilt angle θ.

7. The manufacturing method according to any one of claims 4 to 6, wherein
the battery case (10) is formed with aluminum or resin.

8. The manufacturing method according to any one of claims 3 to 7, wherein
the upper limit threshold LMAX is set to be within a range from 0.05% to 10%.

9. The manufacturing method according to any one of claims 3 to 8, wherein
the inspection liquid amount L1 is measured at a time when a SOC of the battery assembly (1) has reached a predetermined inspection value set to be within a range from 60% to 90%.

10. A battery pack (100), at least comprising:

plural single-batteries (110); and
a connecting member (150) configured to electrically connect each of the plural single-batteries (110), wherein
90% or more of the plural single-batteries (110) are secondary batteries, each comprising an increase amount LΔ of an excess electrolytic solution (32) for an inspection charge for a predetermined period, the increase amount LΔ being equal to or less than a predetermined upper limit threshold LMAX.

11. The battery pack (100) according to claim 10, wherein
all of the plural single-batteries (110) are the secondary batteries, each comprising the increase amount LΔ of the excess electrolytic solution (32) being equal to or less than the upper limit threshold LMAX.

12. The battery pack (100) according to claim 10 or 11, wherein
20 or more of the single-batteries (110) are provided.

FIG.1

FIG.2

FIG.3

START

Measurement of $L_0$ — S21

Start of inspection charge — S22

Measurement of $L_1$ — S23

Obtainment of $L_T$ — S24

Calculation of $L_\Delta$ — S25

END

FIG.4

FIG.5

FIG.6

FIG.7

FIG.8

FIG.9

START

Construction of
battery assembly — S10

Measurement of $L_\Delta$ — S20

S30

$L_\Delta \leq L_{max}$? — No

Yes

S60

$L_\Delta \geq L_{min}$? — No

Yes — S40

Labeling of good
quality product

S50

Labeling of bad
quality product

END

FIG.10

Europäisches
Patentamt

European
Patent Office

Office européen
des brevets

# EUROPEAN SEARCH REPORT

Application Number

EP 23 20 9037

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2021 170436 A (TOYOTA MOTOR CORP) 28 October 2021 (2021-10-28) | 1-12 | INV. H01M10/48 H01M10/04 G01R31/387 G01R31/392 G01R31/396 H01M10/42 H01M50/204 |
| Y | * page 2, paragraph 0007 - page 8, paragraph 0060; figures 1-13 * | 4-6,8 | |
| X | US 2017/005373 A1 (TASHIRO HIROKI [JP]) 5 January 2017 (2017-01-05) | 1-3,7, 9-12 | |
| Y | * page 2, paragraph 0033 - page 11, paragraph 0129; figures 1-17 * | 4-6,8 | |
| | ----- | | ADD. H01M10/0525 |

TECHNICAL FIELDS
SEARCHED        (IPC)

H01M
G01R

The present search report has been drawn up for all claims

| Place of search | Date of completion of the search | Examiner |
|---|---|---|
| Munich | 22 April 2024 | Polisski, Sergej |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

....................................................................

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 23 20 9037

This annex lists the patent family members relating to the patent documents cited in the above-mentioned European search report.
The members are as contained in the European Patent Office EDP file on
The European Patent Office is in no way liable for these particulars which are merely given for the purpose of information.

22-04-2024

| Patent document cited in search report | | Publication date | Patent family member(s) | | Publication date |
|---|---|---|---|---|---|
| JP 2021170436 | A | 28-10-2021 | NONE | | |
| US 2017005373 | A1 | 05-01-2017 | CN 106104905 | A | 09-11-2016 |
| | | | DE 112014006020 | T5 | 20-10-2016 |
| | | | JP 6102734 | B2 | 29-03-2017 |
| | | | JP 2015127991 | A | 09-07-2015 |
| | | | US 2017005373 | A1 | 05-01-2017 |
| | | | WO 2015097516 | A1 | 02-07-2015 |

EPO FORM P0459

For more details about this annex : see Official Journal of the European Patent Office, No. 12/82

**EP 4 395 002 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021170436 A
- JP 2022044621 A
- JP 2021182474 A